# EUROPEAN PATENT APPLICATION

(11) **EP 2 395 824 A1**
(43) Date of publication of application: **14.12.2011**
(21) Application number: 11158348.0
(22) Date of filing: 15.03.2011
(51) Int. Cl.: H05K 3/34

(54) **Mount structure, electronic apparatus, stress relieving unit, and method of manufacturing stress relieving unit**

(30) Priority: 10.06.2010 JP 2010133373
(71) Applicant: FUJITSU LIMITED, Kawasaki-shi, Kanagawa 211-8588 (JP)
(72) Inventor: Kitajima, Masayuki, Kawasaki-shi Kanagawa 211-8588 (JP); Okada, Toru, Kawasaki-shi Kanagawa 211-8588 (JP); Kobayashi, Hiroshi, Kawasaki-shi Kanagawa 211-8588 (JP); Emoto, Satoshi, Kawasaki-shi Kanagawa 211-8588 (JP)
(74) Representative: Holz, Ulrike

(57) **Abstract**

A mount structure for mounting an electronic component on a circuit board includes a stress relieving unit including a center portion having a smaller cross section than a cross section of ends of the stress relieving unit; a first joint portion configured to join one end of the stress relieving unit onto an electrode pad of the electronic component; a second joint portion configured to join the other end of the stress relieving unit onto a connecting pad of the circuit board. Hollow spaces are provided between plural joint structures each of which includes the first joint portion, the stress relieving unit, and the second joint portion.

## Description

### FIELD

The embodiments discussed herein are related to a mount structure for mounting an electronic component on a circuit board, electronic apparatus, stress relieving unit, and a method of manufacturing stress relieving unit.

### BACKGROUND

Typically, an electronic apparatus includes a circuit board on which electronic components, such as semiconductor devices, are mounted. Electronic apparatuses generally have become smaller in size in recent years, with a resultant decrease in the size of circuit boards built inside them, which may be enabled by high-density mounting technology. The electronic components mounted on the circuit board, such as semiconductor devices, have also become smaller. As a result, the size of a mount structure for mounting the electronic components on the circuit board has also been reduced.

The semiconductor devices may be mounted on the circuit board using solder bumps as a joining material. For example, a solder joint produced by solder bumps mechanically fixes a semiconductor device on the circuit board as well as providing electrical connections between them. As the size of the mount structure and that of solder bumps become smaller, the size of the soldered joint portion also needs to be reduced. Smaller solder bump joint portions tend to be more easily deformed and damaged by thermal stress or external pressure, resulting in defective connections.

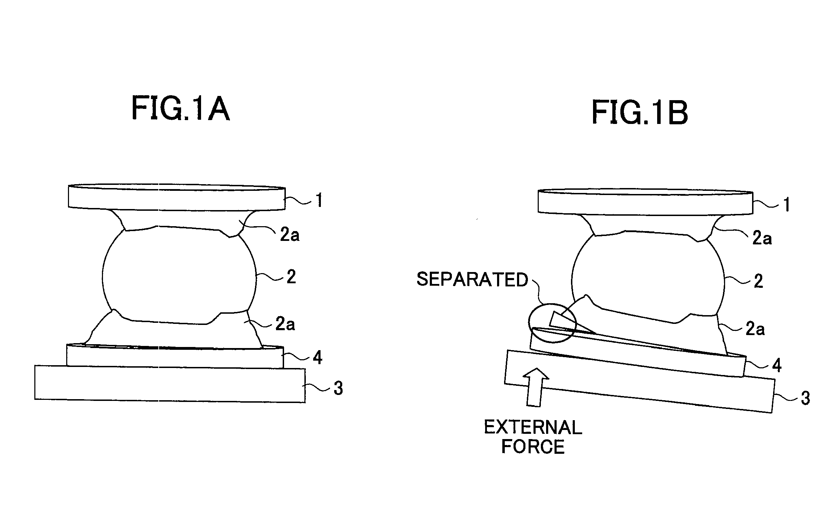

Deformation of a solder bump upon application of external force to a solder bump joint portion as a mount structure is described with reference to FIGs. 1A and 1B. FIG. 1A illustrates the mount structure in which an electrode pad 1 of a semiconductor device (not shown) is joined to a connecting pad 4 of a circuit board 3 via a solder bump 2. Upon solder reflow, the solder bump 2 melts and then solidifies, forming soldered joint portions 2a closely adhered onto the electrode pad 1 and the connecting pad 4. The state illustrated in FIG. 1A is prior to the application of external force, so that the solder bump 2 is not deformed.

When an external force acts on the circuit board 4 as illustrated in FIG. 1B, the circuit board 3 is deformed and raised where the external force is applied, thus deforming the solder bump 2. Because the external force is applied away from the center of the solder bump 2, stress is concentrated at the edge of the soldered joint portion 2a closer to the location of the external force. When the external force is removed, the stress is removed so that the deformation of the solder bump 2 is eliminated and the original shape of the solder bump 2 illustrated in FIG. 1A is restored.

When such external force is applied to the circuit board 3 repeatedly, stress concentration may occur repeatedly between the lower soldered joint portion 2a and the connecting pad 4, for example, possibly resulting in separation of the edge of the lower soldered joint portion 2a from the connecting pad 4. If such a separation develops further inside, the electric connection between the lower soldered joint portion 2a and the connecting pad 4 may be lost, resulting in defective connection.

The soldered joint portions 2a may be reinforced by filling the space between the semiconductor device and the circuit board 3 with an underfill material. For example, areas around the soldered joint portions 2a are filled with epoxy resin so as to reinforce the soldered joint portions 2a from the surrounding areas, while the bottom surface of the semiconductor device (not shown) is bonded to the surface of the circuit board 3 using the underfill material, thus mechanically fixing the semiconductor device onto the circuit board 3. In this way, improved pressure resistance and long-term reliability of the soldered joint portions 2a can be obtained.

Electronic apparatuses, such as portable computers and mobile phones, are increasingly becoming smaller in size and versatile in function. As a result, a pressure applied to the housing of such an electronic apparatus is more readily transmitted to the internal circuit board or the mount structure. Thus, in order to further improve pressure resistance and long-term reliability of the soldered joint portions, underfill materials with higher bonding strength and higher Young's modulus are increasingly used in recent years. However, when the bonding strength of the underfill material is increased, it becomes more difficult to remove the semiconductor device from the circuit board.

For example, when a functional failure occurs in one of the semiconductor devices mounted on the circuit board, one cannot remove the failed semiconductor device alone from the circuit board for replacement. Instead, the expensive circuit board as a whole needs to be replaced, resulting in an increase in defective work cost for the circuit board. Further, one cannot examine only the function of the semiconductor device suspected of having developed a functional failure for analysis of the cause of failure. As a result, the cause of the functional failure cannot be determined, possibly resulting in an increase in defective rate.

A mount structure has been proposed whereby a spacer sheet or piece is inserted between the circuit board and the semiconductor device in order to reinforce the joints between the semiconductor device and the circuit board, so that the deformation of the circuit board due to external pressure can be prevented, as discussed in Japanese Laid-Open Patent Publication Nos.5-6920, 2006-287091, 2001-217281, and 2001-203237.

However, the mount structures discussed in the aforementioned publications are configured to eventually fill the space between the semiconductor device and the circuit board with underfill material so as to bond or fix the semiconductor device onto the circuit board. Thus, although these mount structures may be capable of reinforcing the joint portions of the semiconductor device, they are not designed to enable the easy removal of the semiconductor device from the circuit board.

### SUMMARY

In view of the above-mentioned conventional problems, the present disclosure aims at providing a mount structure that provides improved pressure resistance and long-term reliability of a joint portion of a semiconductor device mounted on a circuit board without using an underfill material, and that enables the semiconductor device to be easily removed from the circuit board.

According to an embodiment of the present invention, a mount structure for mounting an electronic component on a circuit board includes a stress relieving unit including a center portion having a smaller cross section than a cross section of ends of the stress relieving unit; a first joint portion configured to join one end of the stress relieving unit onto an electrode pad of the electronic component; a second joint portion configured to join the other end of the stress relieving unit onto a connecting pad of the circuit board. Hollow spaces are provided between plural joint structures each of which includes the first joint portion, the stress relieving unit, and the second joint portion.

In another embodiment, an electronic apparatus includes a circuit board on which an electronic component is mounted via the mount structure.

In another embodiment, a stress relieving unit disposed in a joint portion between an electrode pad of an electronic component and a connecting pad of a circuit board includes an upper flange joined to the electrode pad of the electronic component; a lower flange joined to the connecting pad of the circuit board; and a center portion extended between the upper flange and the lower flange. A cross section of the center portion is smaller than a cross section of the upper flange and the lower flange.

In another embodiment, a method of manufacturing a stress relieving unit disposed in a joint portion between an electrode pad of an electronic component and a connecting pad of a circuit board includes forming plural through-holes having a constricted shaped cross section in a sheet material; filling the through-holes with a metal; and punching the sheet material into portions including the through-holes filled with the metal.

### BRIEF DESCRIPTION OF DRAWINGS

FIG. 1A illustrates a solder bump before application of external force;

FIG. 1B illustrates a deformation of a solder bump upon application of external force to a solder bump joint portion as a mount structure;

FIG. 2 is a side view of a semiconductor device mounted on a circuit board using a mount structure according to an embodiment of the present invention;

FIG. 3 is a perspective view of a spacer;

FIGs. 4A, 4B, and 4C illustrate the mechanism of stress reduction by the spacer;

FIGs. 5A, 5B, and 5C illustrate a method of manufacturing the spacer of FIG. 3;

FIG. 6 is a perspective view of a variation of the spacer;

FIG. 7 illustrates a method of manufacturing the spacer of F'IG. 6;

FIG. 8 is a perspective view of another variation of the spacer 16;

FIG. 9 is a perspective view of an example of the spacer in which a center portion is displaced from the center of the spacer;

FIG. 10 is a perspective view of another example of the spacer in which the center portion is displaced from the center of the spacer;

FIG. 11 is a perspective view of another example of the spacer in which the center portion is displaced from the center of the spacer;

FIGs. 12A, 12B, and 12C illustrate various steps of a method of manufacturing the spacer of FIG. 11;

FIGs. 13A through 13F illustrate a method of manufacturing the spacer by copper plating;

FIGs. 14A and 14B are cross sections of shapes of a through-hole;

FIGs. 15A through 15F illustrate various steps of a method of manufacturing the spacer using an indium alloy solder;

FIGs. 16A and 16B are cross sections of shapes of a through-hole; and

FIG. 17 is a perspective view of a laptop computer built inside with a circuit board on which semiconductor devices are mounted using the spacer according to an embodiment of the present invention.

### DESCRIPTION OF EMBODIMENTS

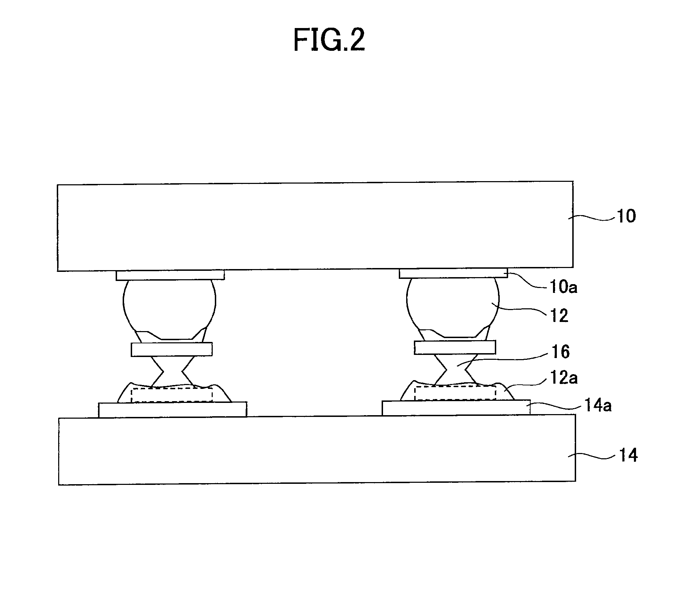

Embodiments of the present invention will be described with reference to accompanying drawings. FIG. 2 is a side view of a semiconductor device 10 mounted on a circuit board 14 via a mount structure according to an embodiment of the present invention. A solder bump 12 disposed on an electrode pad 10a of the semiconductor device 10 is joined to a connecting pad 14a of the circuit board 14 via a spacer 16 as a stress relieving unit. The spacer 16 may be formed of a copper material having springiness, such as oxygen-free copper (C1020) or tough pitch copper (C1100).

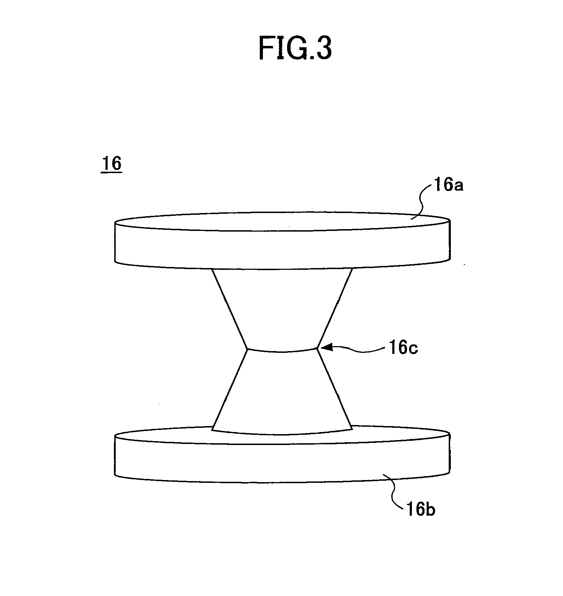

FIG. 3 is a perspective view of the spacer 16. The spacer 16 includes an upper flange 16a, a lower flange 16b, and a center portion 16c between them. The center portion 16c has a constricted shape with a smaller cross section at the middle (which may be referred to as a "constricted portion") than the cross section at either end. As will be described later, the lower flange 16b can be slightly inclined with respect to the upper flange 16a at the constricted portion. In other words, when an external force is applied to the mount structure, resultant stress can be relieved by the constricted portion of the mount structure. Thus, stress concentration between the soldered joint portion 12a (see FIG. 2) and the upper flange 16a can be prevented, so that the separation of the soldered joint portion 12a can be prevented.

Upon solder reflow of the solder bump 12, the upper flange 16a of the spacer 16 is joined to the molten solder bump 12, forming a first joint portion. At the same time, the lower flange 16b of the spacer 16 is joined to the connecting pad 14 by the molten solder bump 12, forming a second joint portion. Prior to solder reflow, the connecting pad 14a may be coated with a solder paste so that the lower flange 16b of the spacer 16 can be joined to the connecting pad 14a via the solder paste, thus forming the second joint portion.

Thus, the electrode pad 10a of the semiconductor device 10 is electrically and mechanically connected to the connecting pad 14a of the circuit board 14 via the solder bump 12 and the spacer 16. In accordance with the present embodiment, no underfill material is filled between the semiconductor device 10 and the circuit board 14, as in a conventional mount structure. In other words, the mount structure according to the present embodiment does not require reinforcement of the joint portions using underfill material. Therefore, hollow spaces remain between adjacent connecting portions (each including the first joint portion, the spacer 16, and the second joint portion).

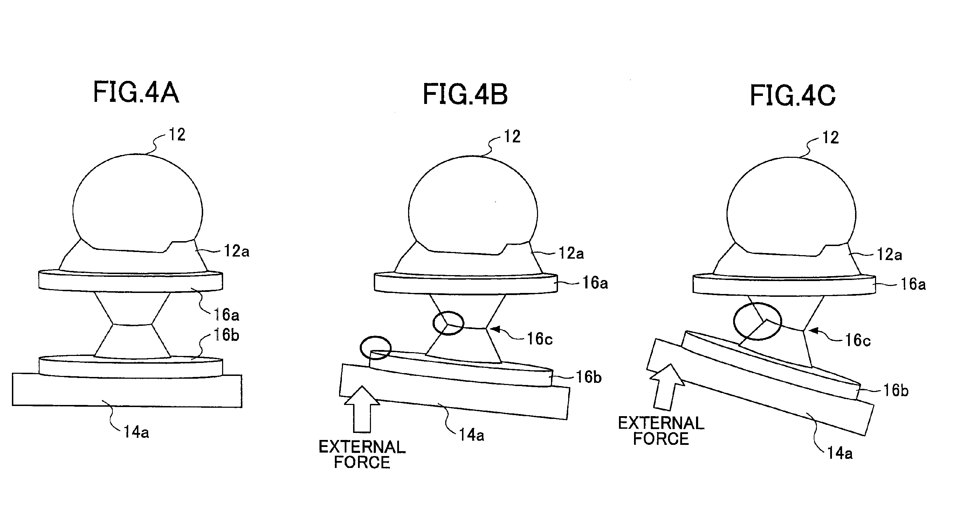

The mechanism of stress relief by the spacer 16 as a stress relieving unit is described with reference to FIGs. 4A, 4B, and 4C. FIG. 4A is a side view of the spacer 16 before external force is applied to the circuit board 14. FIG. 4B is a side view of the spacer 16 that has been slightly deformed by the application of external force to the circuit board 14. FIG. 4C is a side view of the spacer 16 that has been further deformed by the application of external force to the circuit board 14. FIGs. 4A, 4B, and 4C do not illustrate the semiconductor device 10, the electrode pad 10a, and the circuit board 14 for simplicity. While FIGs. 4A, 4B, and 4C illustrate the deformation of the spacer 16 accompanying the deformation of the circuit board 14 due to the application of external force to a position of the circuit board 14, the circuit board 14 may be deformed by thermal stress caused in the circuit board 14.

When no external force is applied to the circuit board 14, the upper flange 16a and the lower flange 16b of the spacer 16 are parallel to each other, as illustrated in FIG. 4A, and the solder bump 12 is supported by the spacer 16. When external force is applied to the circuit board 14, the circuit board 16 is inclined, as illustrated in FIG. 4B. As a result, the lower flange 16b of the spacer 16 is slightly inclined with respect to the upper flange 16a. As the external force applied to the circuit board 14 is increased, the circuit board 16 is further inclined and the inclination of the lower flange 16b with respect to the upper flange 16a increases, as illustrated in FIG. 4C. Such a large inclination of the lower flange 16b with respect to the upper flange 16a is enabled by the constricted portion of the center portion 16c of the spacer 16. Namely, because the constricted portion of the center portion 16c of the spacer 16 has a smaller cross section than the other portions of the center portion 16c, stress tends to be concentrated at the constricted portion, which can be more easily deformed. Because the spacer 16 is made of a copper material having springiness, the concentration of stress in the constricted portion may deform the spacer 16 but does not destroy it.

Thus, because the constricted portion of the center portion 16c of the spacer 16 is easily deformed or bent, most of the stress produced by the external force as it acts on the circuit board 14 is absorbed by the constricted portion. In this way, the stress that develops between the soldered joint portion 12a of the solder bump 12 and the upper flange 16a of the spacer 16 is relieved, thus preventing the separation of the soldered joint portion 12a from the upper flange 16a as well as the separation of the lower flange 16b from the connecting pad 14a.

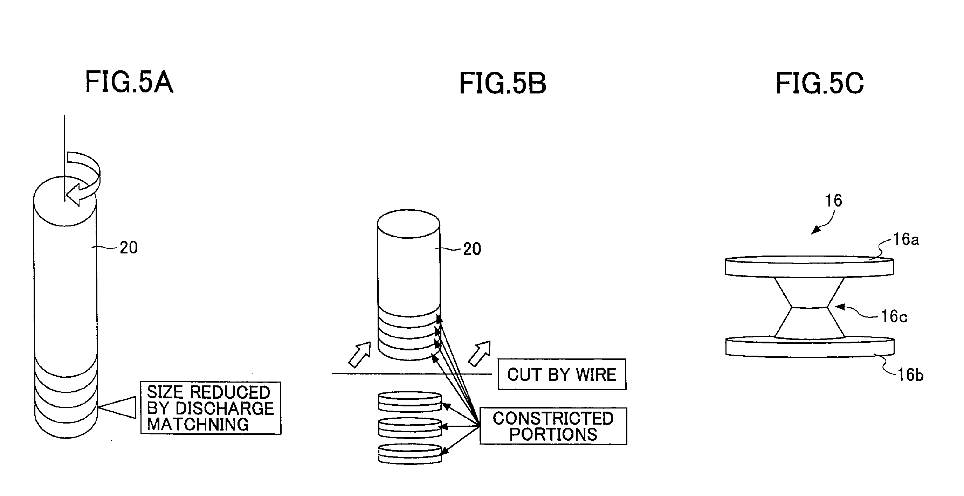

A method of manufacturing the spacer 16 is described with reference to FIGs. 5A, 5B, and 5C. First, a tough pitch copper rod 20 with a diameter of 0.3 mm, for example, is prepared. Then, as illustrated in FIG. 5A, the circumferential surface of the tough pitch copper rod 20 is subjected to electric discharge machining in order to form areas that constitute the center portion 16c having the constricted portion on the tough pitch copper rod 20. Then, as illustrated in FIG. 5B, the tough pitch copper rod 20 is cut into portions of widths of 0.1 mm, for example, by wire electric discharge machining, each of the portions having areas corresponding to the center portion 16c, the upper flange 16a, and the lower flange 16b. In this way, as illustrated in FIG. 5C, there is obtained a number of the spacers 16 each having a height of 0.1 mm and including the center portion 16c with the constricted portion. On either end of the center portion, there are formed the upper flange 16a and the lower flange 16b both having the diameter of 0.3 mm.

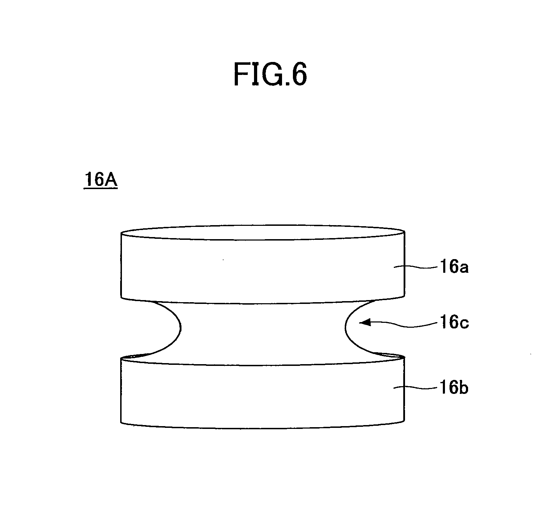

The measurements of the spacer 16 are not limited to the above values and may be set according to the particular measurements of the electrode pad of the semiconductor device that is mounted, for example. The shape of the spacer 16 is not limited to the shape illustrated in FIG. 3 and may include various other shapes. For example, FIG. 6 is a perspective view of a variation of the spacer 16. The spacer 16A differs from the spacer 16 in the shape of the constricted portion of the center portion 16c. Specifically, while the constricted portion of the spacer 16 is linear, the constricted portion of the spacer 16A has a curvature.

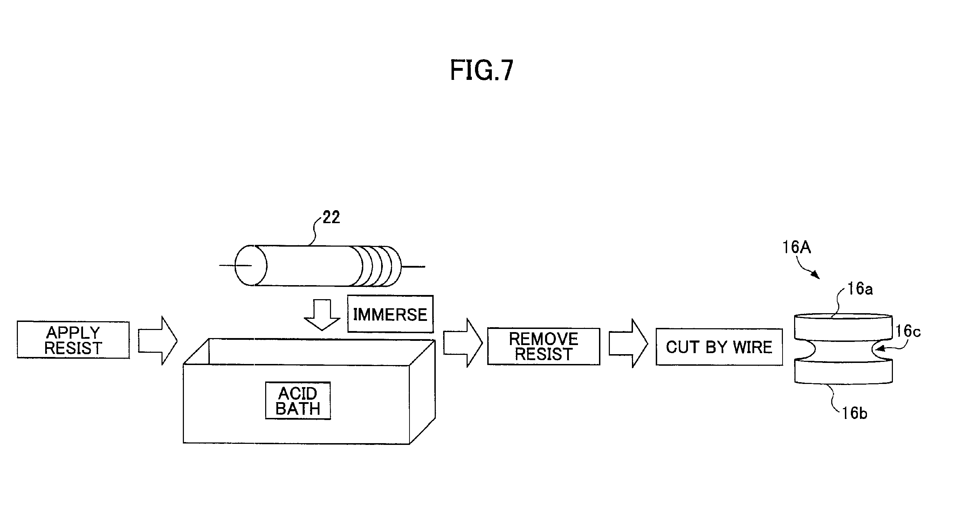

The center portion 16c of the spacer 16A may be easily formed by etching. FIG. 7 illustrates a method of manufacturing the spacer 16A. First, a brass rod 22 with a diameter of 0.4 mm, e.g., is prepared. The peripheral surface of the brass rod 22 is then masked with a coat of photoresist leaving unmasked bands with a width of 0.1 mm around the brass rod 22. Then, the brass rod 22 is immersed in an acid bath and etched, whereby round concave portions are formed in the unmasked portions on the circumferential surface of the brass rod 22. After the concave portions with an appropriate depth are obtained, the brass rod 22 is removed from the acid bath, washed, and then the photoresist is removed. Thereafter, the brass rod 22 may be cut by wire electric discharge machining into portions with a width of 0.2 mm, for example, each of the portions having areas corresponding to the center portion 16c, the upper flange 16a, and the lower flange 16b. The concave portion formed by the above etching process corresponds to the constricted portion of the center portion 16c. Thus, there is formed the spacer 16A having a height of 0.2 mm and including the center portion 16c with the constricted portion. On either end of the center portion 16c, there are formed the upper flange 16a and the lower flange 16b both having a diameter of 0.4 mm. The measurements of the spacer 16A are not limited to the above values and may be set according to the particular measurements of the electrode pad of the semiconductor device that is mounted, for example.

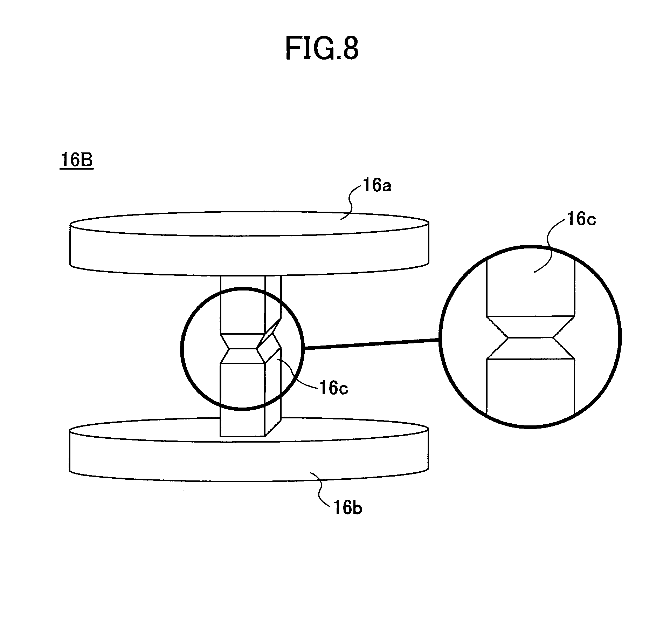

FIG. 8 is a perspective view of another variation of the spacer 16. The spacer 16B according to this variation differs from the spacer 16A in the shape of the center portion 16c. Specifically, the center portion 16c of the spacer 16B includes a long and thin square pillar, in a middle portion of which a small cut-out is formed. The cut-out provides the constricted portion, which makes it easier for the spacer 16B to be easily deformed at the constricted portion where stress can be concentrated.

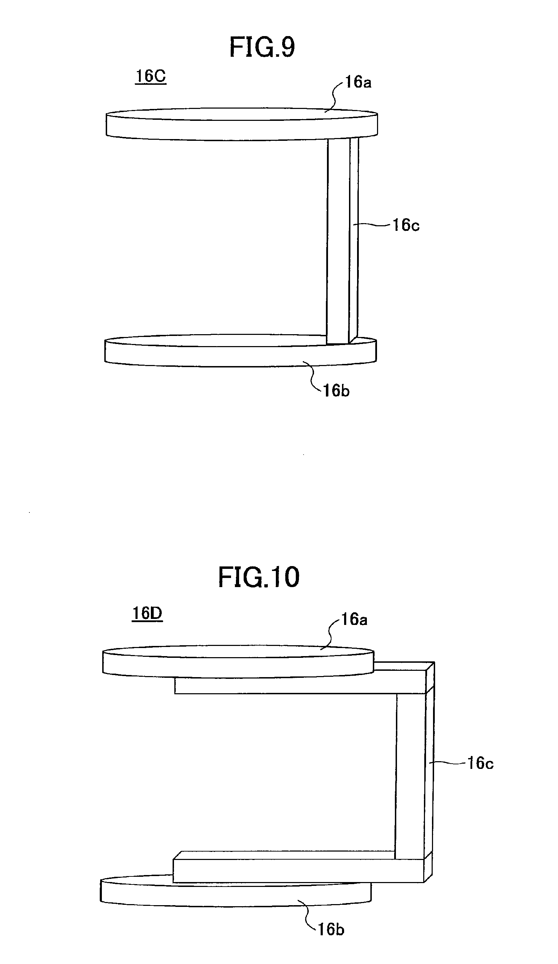

While the spacers 16, 16A, and 16B according to the foregoing embodiments have the center portion 16c located at the center of the upper flange 16a and the lower flange 16b, the center portion 16c may be located in other positions. For example, FIG. 9 illustrates a spacer 16C having a center portion 16c which includes a long and thin square pillar extending between the upper flange 16a and the lower flange 16b. Specifically, the center portion 16c is disposed not at the center of the upper flange 16a and the lower flange 16b but at a position closer to their outer peripheral portions. In the case of the spacer 16C, the center portion 16c as a whole corresponds to the constricted portion.

FIG. 10 illustrates a spacer 16D whose center portion 16c includes plural long and thin square pillars formed in the shape of U laid on one side. The long and thin square pillar in the middle (bottom of U) of the center portion 16c is disposed outside the outer peripheral portions of the upper flange 16a and the lower flange 16b. The middle portion of the center portion 16c corresponds to the constricted portion.

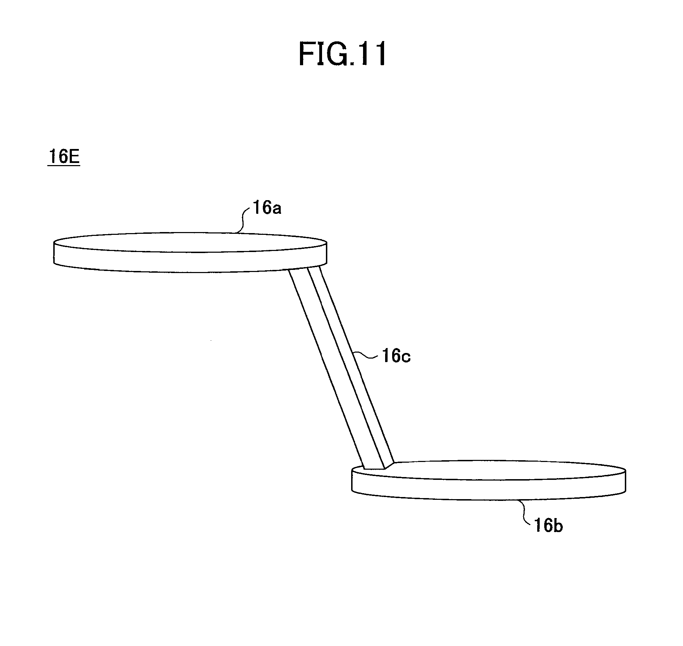

FIG. 11 illustrates a spacer 16E which is a variation of the spacer 16C illustrated in FIG. 9. The spacer 16E includes the upper flange 16a and the lower flange 16b as in the case of the spacer 16C; however, the center portion 16c that connects the upper flange 16a and the lower flange 16b is extended from an outer peripheral portion of the upper flange 16a at an angle, with the other end of the center portion 16c connecting to the lower flange 16b diagonally. The upper flange 16a and the lower flange 16b are extended in opposite directions with respect to the center portion 16c.

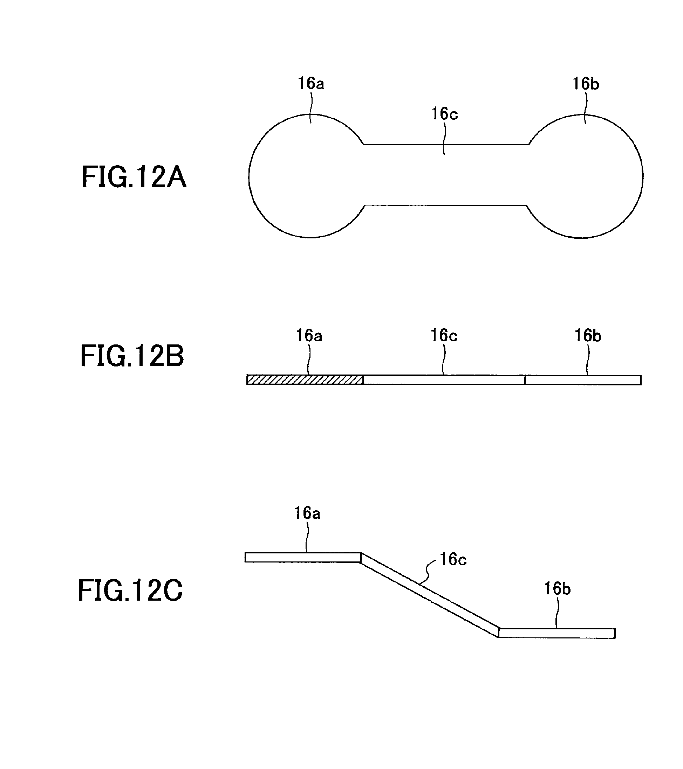

FIG. 12 illustrates a method of manufacturing the spacer 16E illustrated in FIG. 11. The spacer 16E may be easily manufactured by punching and bending a sheet metal. First, a metal plate is cut into a planar shape illustrated in FIG. 11A. FIG. 11B is a side view of the metal plate of FIG. 11A. Then, the metal plate is bent such that the center portion 16c is inclined with respect to the upper flange 16a and the lower flange 16b, as illustrated in FIG. 11C.

In another method, the spacer 16E may be easily manufactured by punching only the upper flange 16a and the center portion 16c out of a metal plate, and then inclining the center portion 16c. Thereafter, the lower flange 16b may be cut or etched out of the metal plate. In this case, a number of spacers 16E may be formed at once from the single metal plate.

Before separating the lower flanges 16b from the metal plate, i.e., when the spacers 16E are still arranged in order in the metal plate, the inclined center portions 16c may be embedded in a resilient resin sheet having a small Young's modulus, and then the lower flanges 16b may be separated from the metal plate. In this case, only the center portions 16c of the spacers 16E are embedded and supported in the resin sheet with the lower flanges 16b arranged in order, such that the upper flanges 16a are disposed on an upper surface of the resin sheet while the lower flanges 16b are disposed on a lower surface of the resin sheet. When cutting the upper flanges 16a and the center portions 16c out of the metal plate, the spacers 16E may be arranged in the same way as the electrodes of the semiconductor devices. In this way, a number of spacers 16E arranged in a manner corresponding to the arrangement of the electrodes can be manufactured at once at the stage of manufacturing the spacers 16E. By using the spacers 16E, spacer manufacturing cost can be significantly reduced.

While the center portion 16c may function as the constricted portion by itself, the center portion 16c may be further provided with a cut-out at a desired position so that stress can be further concentrated at the cut-out portion. The cut-out may be formed simultaneously with the cutting of the center portion without requiring a separate step for forming the cut-out.

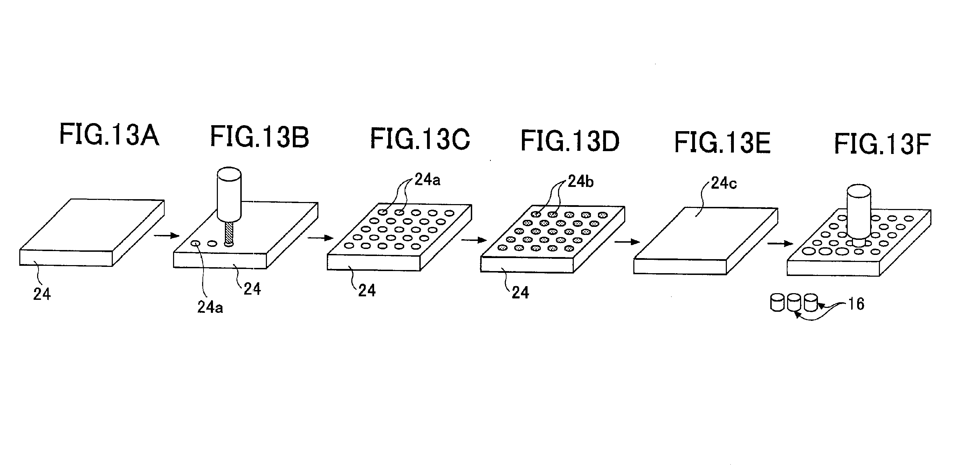

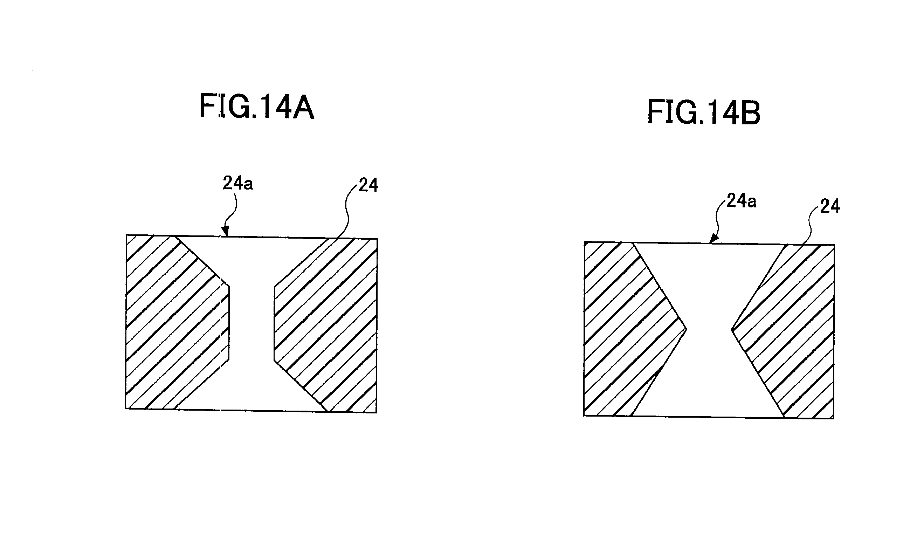

Next, a method of manufacturing the spacer 16 by copper plating is described with reference to FIGs. 13A through 13F. First, an epoxy resin sheet 24 is prepared (FIG. 13A), and then through-holes 24a are formed in the epoxy resin sheet 24 by drilling, for example (FIG. 13B). The through-holes 24a has a shape corresponding to the shape of the center portion 16c of the spacer 16, such as illustrated in FIGS. 14A and 14B. The shape of FIG. 14A may be obtained by first forming a central through-hole using a drill bit with a small diameter, and then countersinking the openings on both ends by the tip of a drip bit having a larger diameter. The shape of FIG. 14B may be formed by countersinking both sides of the epoxy resin sheet 24 by the tip of a drill bit having a large diameter until the countersunk portions are connected to each other in the middle of the epoxy resin sheet 24.

After the through-holes 24a have been completed (FIG. 13C), the through-holes 24a are filled with copper 24b by electroless copper plating (FIG. 13D). Then, a metal plated layer 24c is formed on the entire surfaces of the epoxy resin sheet including the surfaces of the copper in the through-holes 24a. The metal plating may not be provided on the sides of the epoxy resin sheet 24. However, the plating process may be simplified by providing the metal plating on the entire surfaces of the epoxy resin sheet at once. By the plating process, a metal plated layer 24c is formed (FIG. 13E), which forms the upper flange 16a and the lower flange 16b of the spacer 16. Finally, the epoxy resin sheet 24 is punched with a diameter greater than the outer shape of the through-holes 24a (the diameter corresponding to the outer shape of the upper flange 16a and the lower flange 16b), thus obtaining a number of spacers 16 (FIG. 13F).

The spacers 16 may still have some of the epoxy resin sheet 24 remaining on or around the center portion 16c. Such remaining epoxy resin may or may not be removed because the remaining epoxy resin does not prevent the normal functioning of the spacer 16 as a stress relieving unit.

The epoxy resin sheet 24 with the through-holes 24a filled with the copper 24b may be used as a spacer sheet. By arranging the through-holes 24a in the same way as the arrangement of the electrode pads of the semiconductor device, a spacer can be provided for the electrode pads at once by simply placing the epoxy resin sheet 24 between the semiconductor device and the circuit board.

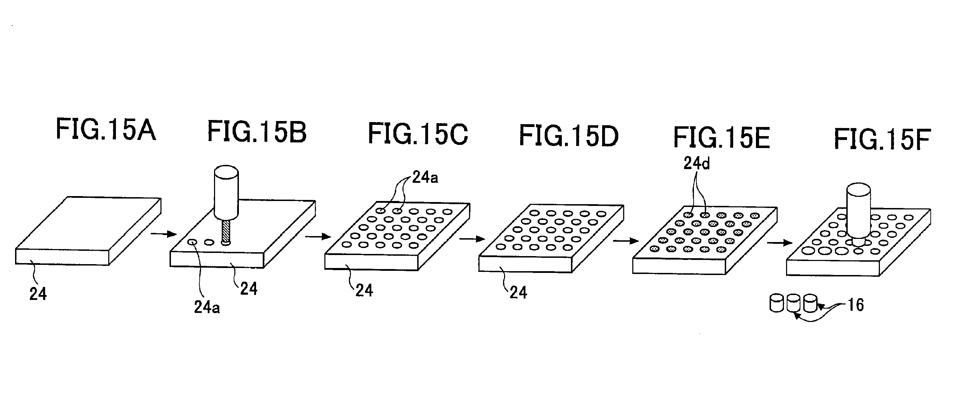

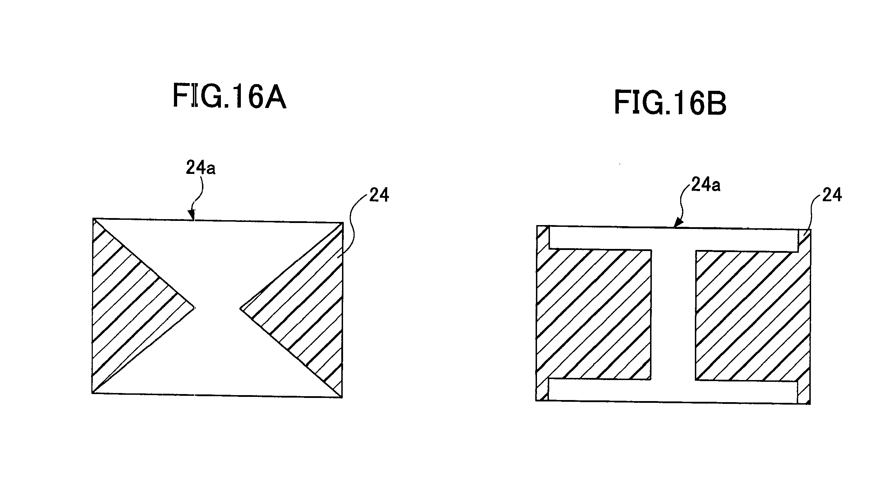

In the method of manufacturing the spacer 16, the through-holes 24a may be filled with an indium alloy solder. FIG. 15 illustrates a method of manufacturing the spacer 16 whose center portion 16c is formed with an indium alloy solder. First, an epoxy resin sheet 24 is prepared (FIG. 15A), and then through-holes 24a are formed in the epoxy resin sheet 24 by drilling, for example (FIG. 15B). The shape of the through-holes 24a corresponds to the shape of the center portion 16c of the spacer 16, such as illustrated in FIGs. 16A and 16B. The shape of FIG. 16A may be obtained by countersinking the epoxy resin sheet 24 on both sides by the tip of a drill bit having a large diameter until the countersunk portions are connected to each other in the middle. The shape of FIG. 16B may be obtained by first forming a central through-hole using a drill bit having a small diameter, and then forming a circular concave portion on both ends of the through-hole.

After the through-holes 24a are formed in the epoxy resin sheet 24 (FIG. 15C), electroless plating process is performed on the inner surfaces of the through-holes 24a (FIG. 15D). Then, the through-holes 24a are filled with an indium alloy solder 24d in a non-oxidizing atmosphere (FIG. 15F). Finally, the epoxy resin sheet 24 is punched to form the outer shape of the through-holes 24a, thus obtaining a number of the spacers 16 (FIG. 15F). The spacers 16 may still have some of the epoxy resin sheet 24 remaining on or around the center portion 16c. Such remaining epoxy resin may or may not be removed because the remaining epoxy resin does not prevent the proper functioning of the spacers 16 as a stress relieving unit.

The epoxy resin sheet 24 with the through-holes 24a filled with the copper may be used as a spacer sheet. By arranging the through-holes 24a in the same manner as the arrangement of the electrode pads of the semiconductor device, a spacer can be provided for the electrode pads at once by simply placing the epoxy resin sheet 24 between the semiconductor device and the circuit board.

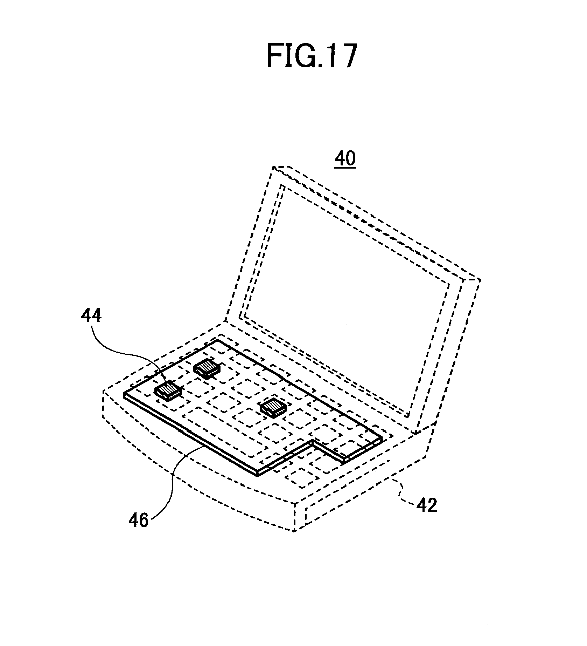

The spacer according to the present embodiment as a stress relieving unit may be used when mounting an electronic component such as a semiconductor device on a circuit board built inside an electronic apparatus. FIG. 17 is a perspective view of a laptop computer 40 containing a circuit board 46 on which semiconductor devices 44 are mounted using a spacer according to an embodiment of the present invention. The laptop computer 40 includes a main body 42 on which a keyboard is provided. The circuit board 46 may be located under the keyboard. When mounting the semiconductor devices 44 on the circuit board 46, the spacer according to the present embodiment is used as a stress relieving unit. The laptop computer 40 is thin and any force applied to the main body 42 may be readily transmitted to the circuit board 46, possibly resulting in a deformation of the circuit board 46. Thus, by using the spacer according to the present embodiment, stress caused in the joint portion of the mount structure can be relieved, so that improved pressure resistance and long-term reliability of the joint portion between the semiconductor device 44 and the circuit board 46 can be obtained.

While solder is used as a joining material in the foregoing embodiments of the present invention, other thermally melting joining materials may be used. The material of the spacer is not limited to copper and may include other electrically conductive material having a certain degree of springiness. For example, the spacer may be made of copper, aluminum, silver, gold, tin, indium, zinc, or an alloy of these metals. The spacer made of such material may be provided with nickel-gold plating or nickel-palladium-gold plating for improved joining property with respect to solder.

Thus, in accordance with the embodiments of the present invention, stress that develops in a joint portion of an electronic component mount structure is relieved by a stress relieving unit, so that the separation of the joint portion from a connected member can be prevented. Thus, improved pressure resistance and long-term reliability of the joint portion of the electronic component can be obtained. As a result, the need for bonding the electronic component onto the circuit board using an underfill can be eliminated, thus enabling the electronic component to be easily removed from the circuit board if need be.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority or inferiority of the invention. Although the embodiments of the present inventions have been described in detail, it should be understood that the various changes, substitutions, and alterations could be made hereto without departing from the spirit and scope of the invention.

## Claims

1. A mount structure for mounting an electronic component on a circuit board, the mount structure comprising:
a stress relieving unit including a center portion having a smaller cross section than a cross section of ends of the stress relieving unit;
a first joint portion configured to join one end of the stress relieving unit onto an electrode pad of the electronic component; and
a second joint portion configured to join the other end of the stress relieving unit onto a connecting pad of the circuit board,
wherein hollow spaces are provided between plural joint structures each of which includes the first joint portion, the stress relieving unit, and the second joint portion.

2. The mount structure according to claim 1, wherein the stress relieving unit includes a spacer formed of a copper material, and
the first and the second joint portions include a soldered joint portion.

3. The mount structure according to claim 1, wherein the stress relieving unit includes an upper flange having a planar shape; and
a lower flange having the same planar shape as the upper flange,
wherein the center portion is extended between the upper flange and the lower flange.

4. The mount structure according to claim 3, wherein the center portion has a constricted shape with a cross section at a middle portion in a longitudinal direction of the center portion smaller than the cross section of the ends of the center portion.

5. The mount structure according to claim 3, wherein the center portion of the stress relieving unit is displaced from the center of the upper flange and the lower flange.

6. The mount structure according to claim 5, wherein the center portion of the stress relieving unit is disposed outside an outer peripheral portion of the upper flange and the lower flange.

7. The mount structure according to claim 1, wherein the stress relieving unit includes a spacer formed of copper, aluminum, silver, gold, tin, indium, zinc, or an alloy of two or more of said metals.

8. The mount structure according to claim 7, wherein the spacer is provided with nickel-gold plating or nickel-palladium-gold plating.

9. An electronic apparatus comprising a circuit board on which an electronic component is mounted via the mount structure according to any one of claims 1 through 7.

10. A stress relieving unit disposed in a joint portion between an electrode pad of an electronic component and a connecting pad of a circuit board,
the stress relieving unit comprising:
an upper flange joined to the electrode pad of the electronic component;
a lower flange joined to the connecting pad of the circuit board; and
a center portion extended between the upper flange and the lower flange,
wherein a cross section of the center portion is smaller than a cross section of the upper flange and the lower flange.

11. The stress relieving unit according to claim 10, wherein the center portion comprises the features as defined in claims 4 to 6.

12. The stress relieving unit according to claim 10, wherein the stress relieving unit is of from copper, aluminum, silver, gold, tin, indium, zinc, or an alloy of two or more of said metals.

13. The stress relieving unit according to claim 12, wherein the stress relieving unit is provided with nickel-gold plating or nickel-palladium-gold plating.

14. A method of manufacturing a stress relieving unit disposed in a joint portion between an electrode pad of an electronic component and a connecting pad of a circuit board,
the method comprising:
forming plural through-holes having a constricted shaped cross section in a sheet material;
filling the through-holes with a metal; and
punching the sheet material into portions including the through-holes filled with the metal.

15. The method of manufacturing a stress relieving unit according to claim 14,
wherein the filling the through-holes with the metal includes filling the through-holes with copper by copper plating, and/or
wherein the filling the through-holes with the metal includes filling the through-holes with an indium alloy solder in a non-oxidizing atmosphere.
